# FASCICULE DE BREVET EUROPEEN

(11) **EP 1 100 118 B1**
(45) Date de publication et mention de la délivrance du brevet: **06.09.2006**
(21) Numéro de dépôt: 99122432.0
(22) Date de dépôt: 10.11.1999
(51) Int. Cl.: H01L 21/308

(54) **Protection par film métallique de la surface d'une structure formée sur un substrat semi-conducteur lors de l'attaque de ce substrat par une solution de gravure KOH**
Schützende Metallschicht für Struktur auf Halbleitersubstrat bei Ätzen mit KOH
Protective metallic film for structure on semiconductor substrate against KOH etchant

(43) Date de publication de la demande: 16.05.2001
(73) Titulaire: EM Microelectronic-Marin SA, 2074 Marin (CH)
(72) Inventeur: Münch, Ulrich, 2000 Neuchatel (CH)
(74) Mandataire: Thérond, Gérard Raymond

(56) Documents cités:
- EP-A- 0 905 495
- US-A- 5 277 756
- US-A- 5 310 449
- US-A- 5 693 181

## Description

La présente invention concerne le domaine des microstructures et en particulier des microstructures réalisées en technologie CMOS sur des substrats semi-conducteur destinés à subir un micro-usinage par gravure chimique humide.

Dans le cadre de certaines applications spécifiques, on réalise communément un micro-usinage par gravure chimique humide d'un substrat semi-conducteur, tel un substrat en silicium, sur lequel ont préalablement été formés des éléments CMOS, tels des circuits intégrés. On produit de la sorte notamment des capteurs intégrés, tel des capteurs de pression, comprenant par exemple une membrane qui est formée en réalisant une cavité dans le substrat semi-conducteur. Les circuits intégrés du capteur sont formés sur une première face ou face avant du substrat semi-conducteur, et la seconde face ou face arrière sur laquelle est préalablement déposée une couche de masquage résistante à la solution de gravure utilisée, est soumise à l'attaque chimique par une solution de gravure adaptée. Un substrat semi-conducteur en silicium peut ainsi être gravé par une solution de gravure tel le KOH, la couche de masquage étant par exemple une couche constituée de nitrure de silicium.

Dans de telles applications, la face du substrat semi-conducteur sur laquelle sont formés les circuits intégrés comprend des zones susceptibles d'être attaquées par l'agent réactif de la solution de gravure. En particulier, le substrat peut comprendre des plages de connexion constituées en aluminium qui peuvent être attaquées par l'agent réactif KOH. Il en résulte la nécessité de protéger de telles zones. On utilise ainsi typiquement un équipement mécanique de protection, tel un équipement en acier inoxydable ou en Téflon (TM), disposé sur la face avant du substrat comprenant les zones susceptibles d'être attaquées par l'agent réactif KOH.

Un inconvénient typique du micro-usinage par gravure chimique au KOH réside donc dans l'utilisation d'un tel équipement mécanique pour protéger les zones concernées, et dans le fait que cette utilisation implique un traitement plaquette par plaquette, ce qui va à l'encontre des préoccupations habituelles en termes de coûts et de rendement dans l'industrie des semi-conducteurs.

On notera que l'homme du métier dispose d'autres solutions de gravure, tel le TMAH (acronyme de l'anglais "Tetra-Methyl-Ammonium Hydroxide") ou EDP (acronyme de l'anglais "Ethylene Diamine Pyrocatechol"), pour remplacer le KOH. Ces solutions de gravure ne présentent pas l'inconvénient d'attaquer les plages de connexion en aluminium et ne nécessitent donc pas l'utilisation d'un équipement mécanique de protection. Néanmoins, ces agents présentent des inconvénients non négligeables.

En effet, par rapport à la solution KOH, les solutions EDP et TMAH sont plus onéreuses et moins stables. La stabilité du KOH est de l'ordre de quelques mois, et celles des solutions TMAH et EDP de l'ordre de quelques heures et quelques minutes, respectivement. On notera également que l'on suspecte la solution EDP d'avoir des propriétés cancérigènes.

Récemment, des techniques ont été développées pour protéger la face frontale du substrat contre l'attaque par la solution KOH au moyen de fins films protecteurs déposés sur cette surface. Un article intitulé "Fluorocarbon film for protection from alkaline etchant" de Y. Matsumoto, issu d'une conférence à Chicago intitulée TRANSDUCERS '97, décrit par exemple l'utilisation d'une couche de protection supplémentaire formée en fluorocarbone.

Un inconvénient d'utiliser un composant tel que le fluorocarbone réside dans le fait que celui-ci nécessite des équipements supplémentaires pour le mettre en oeuvre dans un environnement industriel où il n'est pas communément utilisé.

Un autre inconvénient d'utiliser un tel composant réside dans le fait qu'il n'est pas compatible avec les étapes de photolithographie classique, puisque ce composant nécessite l'utilisation d'une résine spécifique. En outre, on a observé que cette résine est susceptible de se décoller facilement, de sorte qu'elle ne peut être utilisée comme masque en photolithographie.

Un autre désavantage des techniques connues de protection contre l'attaque par la solution KOH faisant appel à des films protecteurs déposés sur la surface du substrat, réside dans le fait qu'elles sont typiquement incompatibles avec le processus standard de formation de plots de connexion électrique, en particulier de plots de connexion électrique en or, ce processus standard étant communément dénommé °gold bumping" en terminologie anglo-saxonne.

On connaît par le document EP-A-0 905 495 une structure formée sur un substrat constitué d'un matériau de base semi-conducteur susceptible d'être attaqué par l'agent réactif KOH, la structure comprenant au moins une zone disposée sur une face avant dudit substrat et constituée d'un matériau susceptible d'être attaqué par ledit agent réactif, la structure comprenant aussi un film résistant audit agent réactif et formé sur ladite face avant de manière à recouvrir au moins ladite zone. Le film résistant à l'agent KOH est constitué de nitrure de silicium. Il sert uniquement à la protection de la structure sous-jacente contre l'action de l'agent réactif KOH.

On connaît par le document US-A-5 693 181 un procédé de fabrication de circuits intégrés comprenant l'étape qui consiste à recouvrir une plaquette en matériau semi-conducteur dans laquelle ont été structurés les circuits d'un masque en nitrure de silicium ou en or résistant à l'agent KOH. Ce masque présente des rainures longitudinales et transversales au niveau desquelles s'opère l'attaque par le KOH pour individualiser les circuits. Le masque en nitrure de silicium ou en or sert uniquement à la protection des circuits sous-jacents contre l'action de l'agent réactif KOH.

Un but de la présente invention est ainsi de proposer une protection de la surface d'une structure formée sur un substrat semi-conducteur, cette protection conférant à la surface de la structure une résistance à l'attaque par la solution de gravure KOH et palliant aux inconvénients susmentionnés.

un autre but de la présente invention est de proposer une telle protection qui est par ailleurs compatible avec les procédés standards de formation de plots de connexion électrique, en en particulier des procédés de formation de plots de connexion électrique en or ou "gold bumping".

Encore un autre but de la présente invention est de proposer une telle protection qui répond par ailleurs aux critères traditionnels dans l'industrie semi-conducteur liés aux coûts, au rendement et à l'environnement, eu égard aux matériaux utilisés pour former cette couche.

A cet effet, la présente invention a pour objet une structure comprenant un substrat semi-conducteur lors de la gravure par KOH dont les caractéristiques sont énoncées à la revendication 8.

La présente invention a également pour objet un procédé de fabrication d'une telle structure dont les caractéristiques sont énoncées à la revendication 1.

Des modes de réalisations avantageux de la présente invention font l'objet des revendications dépendantes.

Un avantage de la présente invention réside dans le fait que le film de protection recouvre les différentes zones susceptibles d'être attaquées par la solution de gravure KOH, notamment les plages de connexion en aluminium, ce qui confère à la structure une protection contre cette solution de gravure. Il en résulte un rendement de fabrication élevé.

Un autre avantage de la présente invention réside dans le fait que le film de protection confère une résistance à la solution réactive de gravure, de sorte que cette structure peut subir un traitement par lot de plaquettes, c'est-à-dire sans avoir recours à un équipement mécanique additionnel pour protéger cette structure plaquette par plaquette.

Encore un autre avantage de la présente invention réside dans le fait que le film de protection est parfaitement compatible avec le processus standard de formation de plots de connexion électriques en or ou "gold bumping".

Ces objets, caractéristiques et avantages, ainsi que d'autres, de la présente invention apparaîtront plus clairement à la lecture de la description détaillée qui suit, faite en référence aux dessins annexés donnés à titre d'exemples non limitatifs et dans lesquels :
- la figure 1 illustre une première variante d'une structure comportant un film métallique de protection selon l'invention;
- la figure 2 illustre une seconde variante d'une structure comportant un film métallique de protection selon l'invention;
- les figures 3a à 3g présentent des étapes de fabrication d'un capteur intégré à membrane diélectrique faisant appel au film métallique de protection selon la présente invention; et
- la figure 4 montre une diagramme de l'évolution du rendement au terme d'une opération de gravure d'une structure employant des films métalliques selon la présente invention.

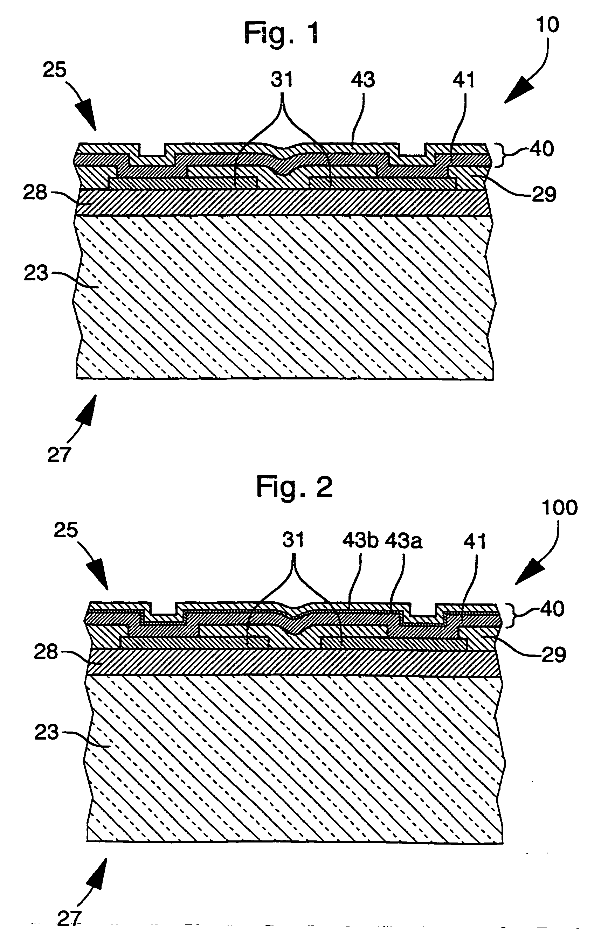

La figure 1 montre une structure, indiquée généralement par la référence numérique 10, formée sur un substrat semi-conducteur 23 ayant une première face 25 ou face avant, et une seconde face 27 ou face arrière. Ce substrat 23 est constitué d'un matériau de base semi-conducteur destiné à être gravé par l'agent réactif KOH. De préférence, ce matériau de base est le silicium.

On notera, dans la suite de la description, que les notions de face avant et de face arrière peuvent être définies pour chacune des couches qui seront formées sur le substrat 23, de sorte que toutes les faces avant sont situées du même côté que la face 25, et que toutes les faces arrières sont situées du même côté que la face 27.

Dans le cas typique de la réalisation d'un capteur intégré à membrane diélectrique, on forme, sur la face avant 25 du substrat 23, une couche diélectrique 28 en oxyde de silicium. La structure 10 comporte par ailleurs une couche de passivation 29, telle une couche en nitrure de silicium, formée de manière à ne pas couvrir au moins une zone 31 constituée d'un matériau susceptible d'être attaqué par l'agent réactif. Les zones 31 dans la figure 1 peuvent notamment être des plages de connexion en aluminium.

Selon la présente invention, un film métallique, repérée par la référence numérique 40 dans la figure 1, comprenant au moins une couche externe en or 43 est déposé sur la face avant du substrat 23. La couche externe d'or 43 est formée dans cet exemple par pulvérisation d'or sur la face avant de la structure 10.

Le film métallique 40 est donc constitué d'au moins une couche externe en or 43 qui présente l'avantage d'être particulièrement résistante à l'attaque par l'agent réactif KOH. Cette couche d'or est donc adaptée pour protéger efficacement les plages de connexion 31 durant la gravure par l'agent réactif KOH.

Préférablement, une couche métallique intermédiaire 41 est déposée sur la face avant de la structure, préalablement au dépôt de la couche externe d'or 43. Cette couche métallique intermédiaire 41 joue le rôle d'une barrière contre la diffusion de l'or dans les couches inférieures formées sur la face avant de la structure 10, notamment la couche d'oxyde de silicium 28. A ce titre, la couche métallique intermédiaire sera également dénommée "barrière de diffusion".

Il est à noter par ailleurs que l'or adhère faiblement sur le silicium. La couche métallique intermédiaire 41 joue donc également le rôle d'un promoteur d'adhésion. Comme on le verra ultérieurement, cette couche métallique intermédiaire 41 est préférablement constituée d'un matériau métallique ou d'une combinaison des matériaux métalliques choisi parmi le Ti, TiW, TiN ou TiW:N.

Comme on le verra ci-après plus en détail, la présente invention s'avère particulièrement avantageuse dans le cas où la structure est destinée à subir une opération de formation de plots de connexion électrique ou "bumps". En particulier, la présente invention s'avère particulièrement avantageuse dans le cas où la structure doit subir une opération de formation de plots de connexion électrique en or, plus communément connue par la terminologie anglo-saxonne "gold bumping". Dans un tel cas, la couche externe d'or 43 forme communément un contact électrique lors de la formation des plots de connexion électrique ou "bumps". A ce titre, la couche externe d'or sera également dénommée "base de plaquage" ou "base d'électrodéposition".

La figure 2 montre une variante de réalisation de la structure de la figure 1. On notera que la structure 100 illustrée à la figure 2 est sensiblement similaire à la structure 10 de la figure 1. Ainsi, par souci de simplicité, les couches représentées dans la figure 2 communes à cette seconde structure et à la structure de la figure 1 sont repérées par les mêmes références numériques.

Ainsi la structure 100 illustrée à la figure 2 comporte un substrat semi-conducteur 23, une couche diélectrique 28 formée sur la face avant du substrat 23, des plages de connexion 31 et une couche de passivation 29 ne recouvrant pas la totalité des plages de connexion 31.

A la différence de la structure 10 de la figure 1, la structure 100 comporte un film métallique 40 comprenant au moins une couche externe d'or 43 constituée d'une première fine couche d'or 43a et d'une seconde couche d'or 43b plus épaisse. Le film métallique 40 comporte préférablement un couche métallique intermédiaire 41 qui est similaire à la couche métallique intermédiaire de la figure 1 et qui remplit les mêmes fonctions.

La première fine couche d'or 43a est une fine couche d'or pulvérisée servant de contact électrique pour l'électrodéposition de la seconde couche d'or plus épaisse 43b. On verra dans la suite de la présente description que cette variante du film métallique de protection 40 comporte des avantages qui seront ultérieurement présentés de manière détaillée.

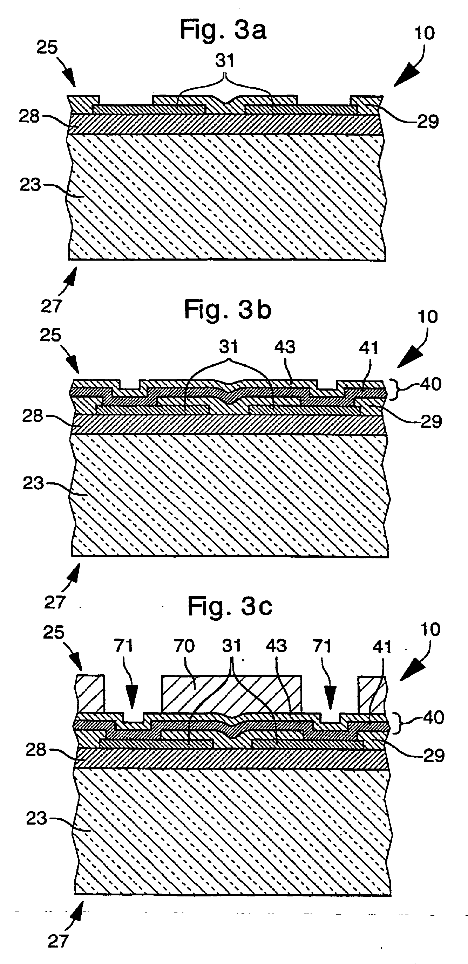

Les figures 3a à 3g montrent des étapes intermédiaires d'un procédé de fabrication d'un capteur intégré à membrane diélectrique dans lequel on utilise avantageusement, selon la présente invention, le film métallique de protection selon la présente invention pour assurer la protection des plages de connexion du capteur lors de l'opération de gravure par l'agent réactif KOH. Des références identiques aux références utilisées dans la figure 1 sont employées pour indiquer les éléments communs.

On notera que dans les figures 3a à 3g, le film métallique 40 comporte une couche métallique intermédiaire 41 et une couche externe d'or 43 réalisée selon l'une ou l'autre des variantes décrites en référence aux figures 1 et 2.

La figure 3a illustre ainsi un stade intermédiaire du procédé de fabrication du capteur intégré à membrane. A ce stade, la structure intermédiaire du capteur, indiquée globalement par la référence numérique 10, présente la couche diélectrique 28, telle une couche d'oxyde de silicium, formée sur la face 25 du substrat 23. Les plages de connexion 31 ainsi que la couche de passivation 29 exposant une partie des plages de connexion 31 ont par ailleurs été formées sur la face avant de la structure 10. La couche de passivation 29 est typiquement une couche en nitrure de silicium ou en oxynitrure de silicium, et les plages de connexion 31 sont typiquement constituées d'aluminium.

A ce stade de la fabrication du capteur intégré, le processus de formation de plots de connexion électrique ou "bumps" peut débuter. Ce processus, plus communément connu par sa dénomination anglo-saxonne "bumping", débute ainsi, comme cela est illustré à la figure 3b, par le dépôt d'un film métallique, indiqué par la référence numérique 40, comprenant au moins une couche externe 43 constituée d'or. Le film métallique 40 comporte par ailleurs une couche métallique intermédiaire, repérée 41, déposée préalablement à la formation de la couche externe d'or 43.

On notera que le film métallique 40 comprenant la couche externe d'or 43 et la couche métallique intermédiaire 41 recouvre toute la surface de la face avant de la structure 10.

La couche métallique intermédiaire 41, entre autres exemples une couche de TiW ou de TiN, est tout d'abord déposée par un processus de pulvérisation sur toute la surface de la face avant de la structure 10, puis la couche externe d'or 43 est déposée sur la couche métallique intermédiaire 41.

Comme cela a déjà été mentionné, la couche métallique intermédiaire 41 remplit essentiellement la fonction d'une barrière de diffusion empêchant la diffusion de l'or dans les couches inférieures de la structure 10. Cette couche métallique intermédiaire 41 remplit, d'autre part, la fonction d'un promoteur d'adhésion améliorant l'adhérence de la couche supérieure d'or 43 sur la face avant de la structure 10. On notera en effet que l'or adhère faiblement sur le silicium.

Selon l'une ou l'autre des variantes décrites en référence aux figures 1 et 2, la couche externe d'or 43 est déposée soit en une étape de pulvérisation (variante de la figure 1) ou en une première étape de pulvérisation d'une fine couche d'or suivie d'une seconde étape d'électrodéposition d'une autre couche d'or (variante de la figure 2).

Au terme du dépôt des couches métalliques 41 et 43 formant le film métallique 40, une étape conventionnelle de photolithographie est exécutée. Comme cela est illustré sur la figure 3c, cette étape de photolithographie comprend le dépôt d'une résine photosensible épaisse 70, suivi de l'insolation et du traitement de cette couche de résine 70 afin d'exposer des zones 71 de dimensions déterminées au-dessus de plages de connexion 31 non couvertes par la couche de passivation 29.

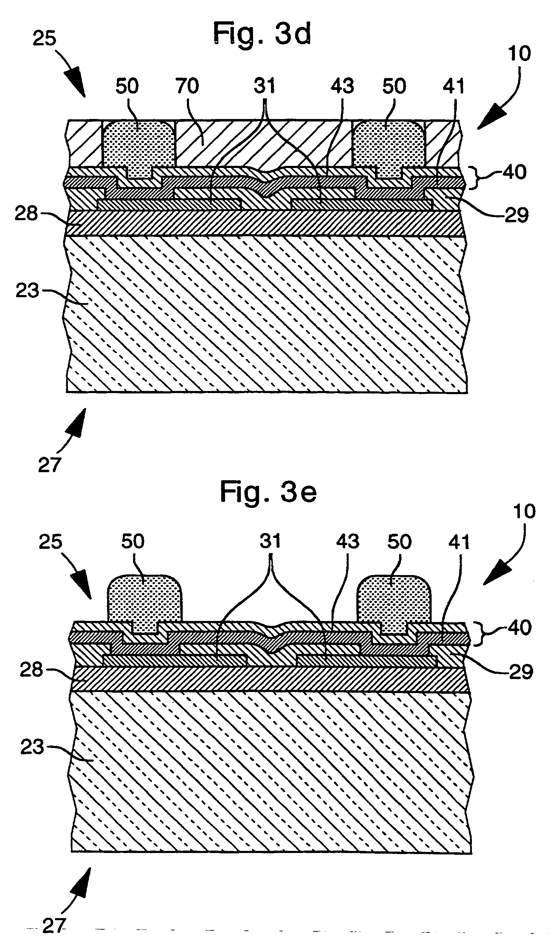

L'étape de photolithographie de la figure 3c est suivie de la formation de plots de connexion électrique en or ou "bumps" 50. Tel que cela est illustré sur la figure 3d, ces "bumps" 50 sont formés par électrodéposition, c'est-à-dire par un dépôt galvanique en utilisant la couche métallique d'or 43 comme contact électrique et la résine structurée 70 comme moule.

A la figure 3e, la résine structurée 70 est ensuite éliminée. A ce stade, on notera que les plots de connexion électrique 50, et a fortiori toutes les plages de connexion 31 présentes sur la face avant de la structure 10, sont court-circuitées par les couches métalliques 41 et 43.

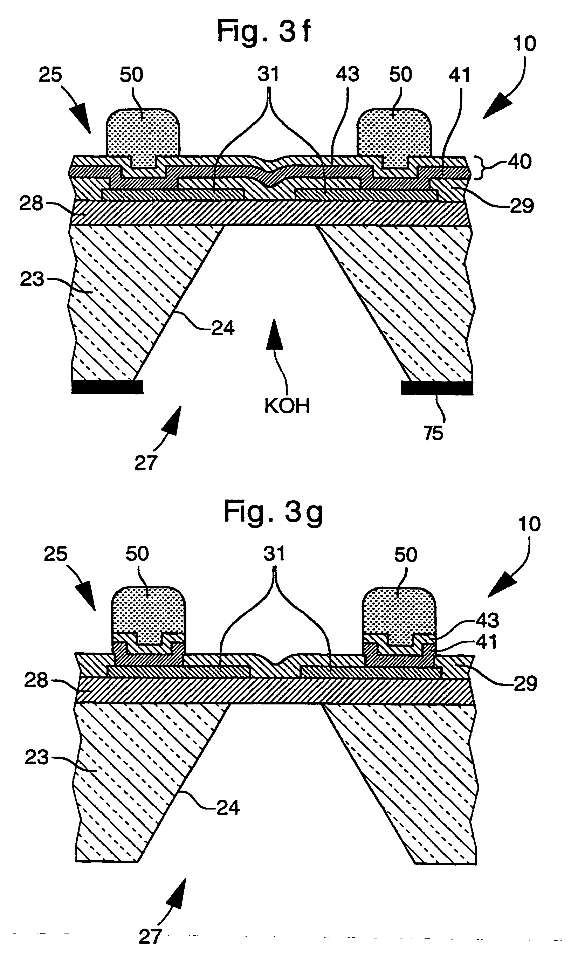

Préalablement à l'opération de gravure illustrée à la figure 3f, une couche de masquage 75, par exemple en nitrure de silicium, est formée sur la face arrière 27 du substrat 23, et cette couche de masquage 75 est traitée de manière à exposer une zone de la face arrière 27 du substrat 23.

Selon la présente invention, l'opération de gravure du substrat 23 par l'agent réactif KOH est effectuée, conformément à l'illustration de la figure 3f, en utilisant le film métallique 40 déposé sur la face avant de la structure 10 comme protection, notamment des plages de connexion 31, contre l'attaque par l'agent réactif KOH. La couche d'or 43 est en effet parfaitement résistante à l'attaque par l'agent réactif KOH et constitue donc une couche de protection idéale pour protéger des zones de la face avant de la structure 10 qui sont susceptibles d'être attaquées par cet agent réactif KOH.

Selon la présente invention, aucun équipement mécanique de protection n'est donc nécessaire pour protéger la face avant de la structure 10 contre l'attaque par l'agent réactif KOH. Ceci permet avantageusement un traitement par lots des plaquettes CMOS et permet ainsi de réduire sensiblement les coûts de fabrication.

Au terme de l'opération de gravure, typiquement après quelques heures dans une solution de KOH, une cavité 24 est ainsi formée dans le substrat 23 jusqu'à atteindre la couche diélectrique 28, comme cela est représenté dans la figure 3f. Une membrane constituée de la zone exposée de la couche diélectrique 28 est ainsi formée.

Lors d'une ultime étape, illustrée à la figure 3g, la couche de masquage 75 formée sur la face arrière du substrat 23 est alors éliminée puis la structure 10 est soumise à une première solution d'attaque permettant d'éliminer la couche externe d'or 43, puis à une seconde solution d'attaque permettant d'éliminer la couche métallique intermédiaire 41. Au terme de ces opérations, les différents plots de connexion électrique 50 sont ainsi séparés électriquement les uns des autres.

En complément de ce qui vient d'être décrit, la Demanderesse a pu observer les effets de différents matériaux sur la qualité de la structure du capteur intégré au terme de l'opération de gravure par l'agent réactif KOH.

En premier lieu, la Demanderesse a ainsi pu faire les constatations suivantes concernant le choix des matériaux constituant la couche métallique intermédiaire ou barrière de diffusion 41. Comme cela a déjà été mentionné plus haut, la couche métallique intermédiaire 41 doit, d'une part, agir comme barrière contre la diffusion de l'or dans les couches inférieures de la face avant de la structure, et, d'autre part, agir comme promoteur d'adhésion de la couche d'or sur la face avant de cette structure.

Le choix s'est ainsi porté sur des matériaux métalliques tel que le Ti, le TiW, le TiN ou le TiW:N. Une couche métallique en TiW:N est typiquement obtenue par pulvérisation d'une couche de TiW dans une atmosphère chargée d'azote, les atomes libres de TiW réagissant dans cette atmosphère avec l'azote pour former du TiN.

Le tableau (1) ci-après présente des valeurs de vitesse de gravure, mesurées par la Demanderesse, pour les matériaux susmentionnés. Ces vitesses de gravure ont été mesurées dans une solution KOH à 95ºC par une mesure de résistivité. Dans ce tableau, et dans les suivants, les indices "A" et "B" entre parenthèses indiquent que les couches correspondantes ont été formées selon deux systèmes distincts de pulvérisation "A" et "B".

**Tableau (1)**

| Matériau | Vitesse de gravure par KOH à 95ºC [nm/h] |
|---|---|
| Ti | 804 |
| TiW _{(A)} | 40 |
| TiW:N _{(A)} | 27 |
| TiW _{(B)} | 17 |
| TiN | 12 |

Du point de vue de la vitesse de gravure, il a ainsi pu être observé, concernant le Ti, une vitesse de gravure trop élevée, de l'ordre de 1 µm par heure, pour que ce matériau soit utilisé comme unique barrière de diffusion. Le Ti, du fait de ses bonnes propriétés d'adhésion et de recouvrement de la surface, à néanmoins été utilisé ultérieurement comme couche additionnelle d'adhésion.

Les autres matériaux métalliques examinés, susceptibles d'être utilisés comme barrière de diffusion, à savoir le TiW, le TiN et le TiW:N, présentent au contraire des vitesses de gravure de l'ordre de quelques dizaines de nanomètres par heure, et semblent donc plus adaptés pour réaliser la couche métallique intermédiaire 41.

On notera que la Demanderesse a également pu observer, concernant le TiW, des différences en termes de vitesse de gravure par le KOH, selon le type de système de pulvérisation utilisé. En effet, les deux systèmes de pulvérisation "A" et "B" utilisés pour former la couche de TiW ont conduit à des différences de l'ordre d'un facteur deux entre les vitesses de gravure de la couche de TiW. Il apparaît ainsi qu'outre le choix du matériau, la méthode de dépôt utilisée pour former la couche métallique intermédiaire doit également être prise en compte. On notera que la pulvérisation de la couche métallique intermédiaire conduit en effet à la formation d'une couche possédant des trous au travers desquels peut potentiellement pénétrer l'agent réactif de gravure.

La Demanderesse a également pu observer des différences en terme d'adhérence entre les différents matériaux susmentionnés. Le tableau (2) suivant illustre ainsi l'adhérence des couches de TiW déposées selon les systèmes "A" et "B" et de la couche de TiN, respectivement, sur le silicium (Si), l'oxynitrure de silicium (SiON), et l'aluminium (Al). Ces valeurs ont été déterminées par un test de traction sous charge progressive. Les forces ayant conduit à une décollement complet de la couche sur le silicium et sur l'aluminium, ainsi qu'à la rupture sur l'oxynitrure de silicium sont indiqués dans la tableau (2).

**Tableau (2)**

| | Adhérence [N] | | |
|---|---|---|---|
| Matériau | Si | SiON | Al |
| TiW _{(A)} | 5.10 | 7.82 | 3.05 |
| TiW _{(B)} | 7.70 | 7.15 | 5.56 |
| TiN | 19.73 | 15.53 | 10.40 |

La Demanderesse a ainsi pu observer un meilleur comportement en terme d'adhérence du TiN par rapport au TiW.

La Demanderesse a encore pu observer des différences au niveau de l'intégrité de la surface du film métallique 40 au terme de la gravure par KOH d'une structure comprenant une couche métallique intermédiaire 41 de composition et d'épaisseur variées et une-couche externe d'or 43 déterminée. Le tableau (3) suivant montre ainsi les résultats des examens, effectués par la Demanderesse, de l'intégrité de surface du film métallique 40 au terme d'une opération de gravure de deux heures dans une solution KOH à 95ºC. Le film métallique 40 était constitué d'une couche métallique intermédiaire 41 d'épaisseur et de composition variées, et d'une couche externe d'or 43 constituée d'une première couche d'or pulvérisée de 0,1 µm d'épaisseur sur laquelle avait été formé un dépôt galvanique d'or de 0,7 µm. L'intégrité de surface des couches à été déterminée optiquement.

**Tableau (3)**

| Matériau | Intégrité de surface |
|---|---|
| TiN 0,1 µm | moyenne |
| Ti 0,03 µm TiN 0,1 µm | faible |
| TiN 0,1 µm Ti 0,1 µm TiN 0,1 µm | moyenne |
| TiW 0,3 µm _{(A)} | bonne |
| TiW:N 0,3 µm _{(A)} | bonne |
| Ti 0,02 µm TiW 0,3 µm _{(A)} | faible |
| TiW 0,3 µm _{(B)} | bonne |
| TiW:N 0,3 µm _{(B)} | faible |

Ce tableau (3) montre en particulier que les couches métalliques intermédiaires comprenant une couche additionnelle de Ti conduisent à des résultats plutôt médiocres, sans doute dus à la vitesse de gravure élevée du Ti dans le KOH qui conduit à un décollement des couches. Le tableau (3) ci-dessus fait en outre ressortir l'importance du choix du système de pulvérisation utilisé pour former la barrière de diffusion 41.

En résumé, il apparaît, des observations effectuées par la Demanderesse, que les candidats pour la réalisation de la couche métallique intermédiaire 41 de la structure sont préférablement le TiW, le TiN ou le TiW:N.

En second lieu, la Demanderesse a également pu faire les constatations suivantes concernant le type de méthode utilisée pour former la couche externe d'or 43. La Demanderesse a ainsi comparé une première couche externe d'or formée par pulvérisation (structure 10 de la figure 1) à une seconde couche externe d'or constituée d'une couche d'or pulvérisée de 0,1 µm d'épaisseur sur laquelle a été formé un dépôt galvanique d'or (structure 100 de la figure 2). Pour un épaisseur totale identique de l'ordre de 0,5 µm, la Demanderesse a ainsi pu observer une meilleure protection contre l'attaque par l'agent réactif KOH avec la seconde couche externe d'or susmentionnée. Aucun changement de résistivité n'a été détecté après une attaque d'une heure par une solution KOH à 95ºC pour cette seconde couche externe d'or. Il est à supposer que l'électrodéposition d'un couche externe d'or conduit à des films d'une plus grande densité offrant une meilleure résistance à l'attaque par l'agent réactif KOH.

La Demanderesse a également pu observer qu'un traitement thermique à 300ºC réduit de manière drastique la qualité de la protection conférée par la couche externe d'or. Des étapes à hautes températures conduisent en effet à l'augmentation de la taille des grains d'or formant ainsi des canaux au travers desquels peut être canalisé l'agent réactif KOH qui atteint alors les couches inférieures de la structure.

La Demanderesse a encore analysé l'efficacité de la protection conférée par un film métallique 40 constitué d'une couche métallique intermédiaire de TiW, déposée selon les deux types de systèmes de pulvérisation à disposition "A" et "B", et d'une couche d'or constituée d'une première couche pulvérisée d'or de 0,1 µm et d'une seconde couche d'or d'épaisseur variée formée par électrodéposition (structure 100 de la figure 2). Le film métallique a été déposé sur des plaquettes de 6 pouces ayant subis les étapes de fabrication CMOS. Ces plaquettes ont été immergées dans une solution KOH à 95ºC durant quatre heures, ce qui est suffisant pour former les membranes diélectriques dans des plaquettes de 600 µm d'épaisseur.

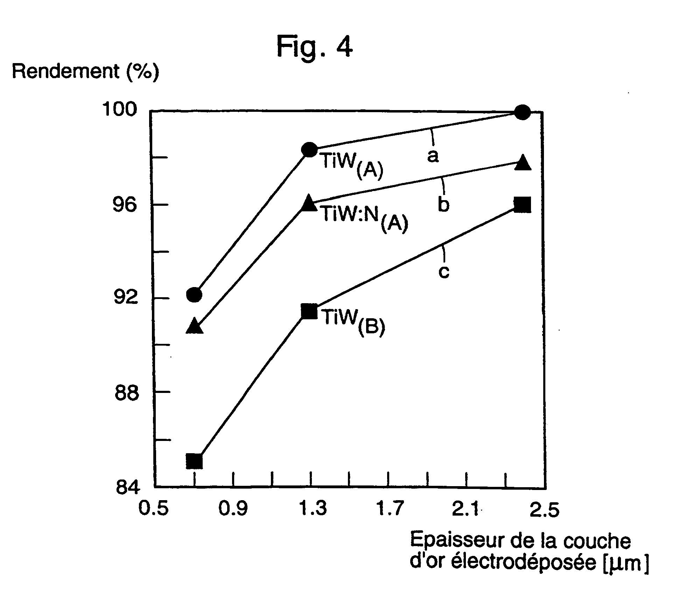

La figure 4 montre un diagramme illustrant l'évolution du rendement des structures en fonction de l'épaisseur de la couche externe d'or formée par électrodéposition. On notera qu'on définit ici le rendement comme étant le pourcentage de plages de connexion non détériorées au terme de l'opération de gravure par l'agent réactif KOH par rapport au nombre total de plages de connexion formées sur un substrat donné.

Dans la figure 4 sont ainsi illustrées trois courbes "a", "b" et "c", montrant l'évolution du rendement des plaquettes en fonction de l'épaisseur de la couche d'or électrodéposée pour trois types de barrières de diffusion en TiW et TiW:N de 0,3 µm d'épaisseur. La courbe "a" montre l'évolution du rendement pour une barrière de diffusion déposée par pulvérisation selon le système "A", la courbe "b" l'évolution du rendement pour une barrière de diffusion déposée par pulvérisation selon le système "A" dans une atmosphère d'azote, et la courbe "c" l'évolution du rendement pour une barrière de diffusion déposée par pulvérisation selon le système "B". Une première couche d'or de 0,1 µm a tout d'abord été pulvérisée pour former une base de plaquage pour l'électrodéposition de la seconde couche d'or. Le rendement a été évalué sur une structure de 5,64 par 4,35 mm².

On constate généralement de la figure 3, que le rendement croît avec l'épaisseur de la couche d'or électrodéposée. D'autre part, le rendement dépend du système de pulvérisation utilisé pour former la barrière de diffusion. Le meilleurs résultats sont obtenus avec la couche de TiW déposée au moyen du système de pulvérisation "A".

La différence de rendement entre les systèmes de pulvérisation "A" et "B" est due à la formation de particules sur la surface de la structure qui conduisent à un décollement des couches métalliques. On notera en effet, que le système de pulvérisation employé "B" est installé dans une chambre blanche de classe 100 alors que le système de pulvérisation "A" est installé dans une chambre blanche de classe 1. On notera par ailleurs que le système de pulvérisation employé "A" utilise une technique de pulvérisation latérale alors que le système de pulvérisation "B" utilise une technique de pulvérisation au-dessus de la cible de sorte qu'un nombre plus élevée de particules de taille élevée dues à l'agglomération de petites particules sont formées avec ce système. Du fait de la technique de pulvérisation latérale employée par le système "A", ces particules agglomérées n'atteignent en principe pas la surface de la cible mais tombent entre le point de pulvérisation et la cible.

Outre l'amélioration constatée par la Demanderesse de la protection conférée par le film métallique comprenant une couche externe galvanique d'or, l'électrodéposition de cette couche permet avantageusement de couvrir les bords de la plaquette, prévenant ainsi l'attaque des côtés de la plaquette par l'agent réactif KOH.

En dernier lieu, la Demanderesse a examiné le rendement de membranes diélectriques formées au terme de la gravure par KOH, c'est-à-dire le pourcentage de membranes intactes au terme de l'opération de gravure. Ce rendement des membranes a été évalué avec un film métallique de protection comprenant une couche galvanique d'or de 1,2 µm sur la face avant de la structure. La Demanderesse a pu observer un rendement des membranes proche de 100% sur un nombre total de 1500 membranes ayant des tailles allant de 350 par 550 µm² à 875 par 1550 µm².

Le film métallique de protection était constitué d'une superposition d'une barrière de diffusion en TiW:N de 0,3 µm d'épaisseur, d'une couche d'or pulvérisée de 0,1 µm d'épaisseur et d'une couche d'or de 1,2 µm d'épaisseur formée par électrodéposition.

Après l'élimination des couches successives du film métallique de protection afin de séparer électriquement les plots de connexion (étape illustrée à la figure 3g), le rendement des membranes était réduit à 89.3%. La raison de cette réduction du rendement est essentiellement due à la contrainte résiduelle en compression dans la couche diélectrique qui conduit à une certaine fragilité de la membrane, et au fait que les couches métalliques de protection ont été éliminées au moyen d'un équipement faisant appel à un spray de solution d'attaque et de rinçage, les liquides d'attaque et de rinçage projetés directement sur les membranes causant ainsi leur destruction éventuelle.

On comprendra que différentes modifications et/ou adaptations peuvent être apportées à la structure et au procédé décrits dans la présente description sans toutefois sortir du cadre de l'invention défini par les revendications annexées. En particulier, on notera que l'homme du métier dispose d'une grande variété de technique permettant d'assurer le dépôt et la formation des diverses couches de la structure selon la présente invention et que certaines étapes peuvent être exécutées selon un ordre chronologique différent.

## Revendications

1. Procédé de fabrication d'une structure comprenant un substrat (23) ayant une première face ou face avant (25), et une seconde face ou face arrière (27), ce substrat (23) étant constitué d'un matériau de base semi-conducteur destiné à être gravé par l'agent réactif KOH, ce procédé comprenant les étapes consistant à :
- former sur ladite face avant (25) au moins une plage de connexion (31) constituée d'un matériau susceptible d'être attaqué par ledit agent réactif KOH;
- former sur la face arrière (27) du substrat (23) une couche de masquage (75) et la traiter de manière à exposer une zone de la face arrière (27) dudit substrat (23);
- former sur toute la surface de ladite face avant (25) de la structure un film métallique (40) comprenant au moins une couche externe d'or (43) de manière à recouvrir ladite plage de connexion (31) et à protéger ladite, plage de connexion (31) contre l'attaque par ledit agent réactif KOH, et
- graver la zone exposée de la face arrière dudit substrat par ledit agent réactif KOH,
ce procédé comprenant l'étape supplémentaire consistant à fermer au moins un plot de connexion électrique (50) sur la couche externe d'or (43) au-dessus de la plage de connexion (31) avant de graver le substrat par l'agent réactif KOH.

2. Procédé de fabrication selon la revendication 1 dans lequel la structure est un capteur intégré à membrane, ce procédé comprenant en outre les étapes consistant à :
- former, avant l'étape de gravure par ledit agent KOH, une couche diélectrique (28) sur ladite face avant (25) du substrat (23) et ladite au moins une plage de connexion (31) sur ladite couche diélectrique (28), et
- graver la face arrière (27) du substrat (23) au moyen dudit agent réactif afin de former une membrane dudit capteur intégré,
**caractérisé en ce que**, lors de l'étape de formation dudit au moins un plot de connexion électrique (50) au-dessus de ladite plage de connexion (31), la couche externe d'or (43) est utilisée comme base de plaquage pour la formation dudit au moins un plot de connexion électrique (50).

3. Procédé selon l'une quelconque des revendications 1 ou 2, **caractérisé en ce que** le plot de connexion électrique (50) est en or et est formé par électrodéposition.

4. Procédé de fabrication selon l'une quelconque des revendications 1 à 3, **caractérisé en ce que**, préalablement à la formation de ladite couche externe d'or (43), on forme une couche métallique intermédiaire (41) sur ladite face avant (25), cette couche métallique intermédiaire (41) agissant comme barrière de diffusion et promoteur d'adhésion.

5. Procédé de fabrication selon la revendication 4, **caractérisé en ce que** ladite couche métallique intermédiaire (41) est constituée de TiW, TiN ou de TiW:N.

6. Procédé de fabrication selon l'une quelconque des revendications 1 à 5, **caractérisé en ce que** ladite couche externe d'or (43) est formée par pulvérisation.

7. Procédé de fabrication selon l'une quelconque des revendications 1 à 6, **caractérisé en ce que**, pour former ladite couche externe d'or (43), on forme une première couche d'or (43a) par pulvérisation, et on forme une seconde couche d'or (43b) au-dessus de ladite première couche d'or par électrodéposition.

8. Structure lors de l'opération de gravure par l'agent réactif KOH, cette structure comprenant un substrat (23) ayant une première face ou face avant (25), et une seconde face ou face arrière (27), ce substrat (23) étant constitué d'un matériau de base semi-conducteur étant grave par l'agent réactif KOH et qui comprend sur sa face arrière (27) une couche de masquage (75) qui expose une zone de la face arrière (27) dudit substrat (23), cette structure comprenant au moins une plage de connexion (31) disposée sur ladite face avant (25) et constituée d'un matériau susceptible d'être attaqué par ledit agent réactif, cette structure comprenant en outre un film métallique (40) formé sur toute la surface de ladite face avant (25) de manière à recouvrir notamment ladite plage (31), ce film métallique (40) comportant au moins une couche externe d'or (43) résistante audit agent réactif, la couche externe d'or (43) supportant au moins un plot de connexion électrique (50) au-dessus de la plage (31).

9. Structure selon la revendication 8, **caractérisée en ce que** le plot de connexion électrique (50) est en or.

10. Structure selon l'une quelconque des revendications 8 ou 9, **caractérisée en ce que** ladite au moins une couche d'or (43) est disposée sur une couche métallique intermédiaire (41) agissant comme barrière de diffusion et promoteur d'adhésion.

11. Structure selon la revendication 10, **caractérisée en ce que** ladite couche métallique intermédiaire (41) est constituée de TiW, TiN ou de TiW:N.

12. Structure selon l'une quelconque des revendications 8 à 11, **caractérisée en ce que** ladite au moins une couche d'or (43) est une couche d'or pulvérisée.

13. Structure selon l'une quelconque des revendications 8 à 11, **caractérisée en ce que** ladite au moins une couche d'or (43) est constituée d'une première couche d'or pulvérisée (43a) et d'une seconde couche d'or (43b) électrodéposée sur ladite première couche d'or (43a).

## Claims

1. Method of manufacturing a structure including a substrate (23) having a first face or front face (25), and a second face or back face (27), this substrate (23) being formed of a semiconductor base material intended to be etched by the KOH reactive agent, this method including the steps consisting in:
- forming on said front face (25) at least one connecting pad (31) formed of a material capable of being etched by said KOH reactive agent;
- forming on the back face (27) of substrate (23) a masking layer (75) and treating it so as to expose a zone of back face (27) of said substrate (23);
- forming on all the surface of said front face (25) of the structure a metallic film (40) comprising at least an external gold layer (43) so as to cover said connection pad (31) and to protect said connection pad (31) from the attack of said reactive agent KOH, and
- etching the exposed zone of the back face of said substrate by said reactive agent KOH,
said process comprising the supplementary step consisting in forming at least one electric connection bump (50) on the external gold layer (43) above the connection pad (31) before etching the substrate by the reactive agent KOH.

2. Manufacturing method according to claim 1 in which the structure is an integrated sensor with a membrane, this method further comprising the steps consisting in:
- forming, before the step of etching by said agent KOH, a dielectric layer (28) on said front face (25) of the substrate (23) and said at least one connection pad (31) on said dielectric layer (28), and
- etching the back face (27) of the substrate (23) by means of said reactive agent in order to form a membrane of said integrated sensor,
**characterized in that**, during the step of forming said at least one electric connection bump (50) above said connection pad (31), the external gold layer (43) is used as a plating base for forming said at least one electric connection bump (50).

3. Manufacturing method according to any of claims 1 or 2, **characterised in that** the electric connecting bump (50) is made of gold and is formed by electro-deposition.

4. Manufacturing method according to any one of claims 1 to 3, **characterised in that**, prior to forming said external gold layer (43), an intermediate metal layer (41) is formed on said front face (25), this intermediate metal layer (41) acting as a diffusion barrier and adhesion promoter.

5. Manufacturing method according to claim 4, **characterised in that** said intermediate metal layer (41) is formed of TiW, TiN or TiW:N.

6. Manufacturing method according to any one of claims 1 to 5, **characterised in that** said external gold layer (43) is formed by sputtering.

7. Manufacturing method according to any one of claims 1 to 6, **characterised in that**, in order to form said external gold layer (43), a first gold layer (43a) is formed by sputtering, and a second gold layer (43b) is formed above said first gold layer (43a) by electro-deposition.

8. Structure during the operation of etching by reactive agent KOH, this structure comprising a substrate (23) having a first face or front face (25) and a second face or back face (27), this substrate (23) being formed of a semiconductor base material being etched by the KOH reactive agent, and which comprises on its back face (27) a masking layer (75) which exposes a zone of the back face (27) of said substrate (23), this structure comprising at least one connection pad (31) disposed on said front face (25) and made of a material capable of being attacked by said reactive agent, this structure further comprising a metallic film (40) formed on all the surface of said front face (25) so as to cover in particular said pad (31), this metallic film (40) including at least an external gold layer (43) resistant to said reactive agent, the external gold layer (43) supporting at least one electric connexion bump (50) above the pad (31).

9. Structure according to claim 8, **characterised in that** the electric connecting bump (50) is made of gold.

10. Structure according to any one of claims 8 or 9, **characterised in that** said at least one gold layer (43) is arranged on an intermediate metal layer (41) acting as a diffusion barrier and adhesion promoter.

11. Structure according to claim 10, **characterised in that** said intermediate metal layer (41) is formed of TiW, TiN or TiW:N.

12. Structure according to any one of claims 8 to 11, **characterised in that** said at least one gold layer (43) is a sputtered gold layer.

13. Structure according to any one of claims 8 to 11, **characterised in that** said at least one gold layer (43) is formed of a first sputtered gold layer (43a) and a second gold layer (43b) electro-deposited on said first gold layer (43a).

## Patentansprüche

1. Verfahren für die Herstellung einer Struktur, die ein Substrat (23) mit einer ersten Seite oder Vorderseite (25) und einer zweiten Seite oder Rückseite (27) umfasst, wobei dieses Substrat (23) aus einem Material auf Halbleiterbasis gebildet ist, das dazu bestimmt ist, mit einem Reaktanten KOH geätzt zu werden, wobei dieses Verfahren die Schritte umfasst, die darin bestehen:
- auf der Vorderseite (25) wenigstens einen Anschlussbereich (31) zu bilden, der aus einem Material gebildet ist, das durch den Reaktanten KOH angegriffen werden kann;
- auf der Rückseite (27) des Substrats (23) eine Maskierungsschicht (75) zu bilden und diese in der Weise zu bearbeiten, dass eine Zone der Rückseite (27) des Substrats (23) freigelegt wird;
- auf der gesamten Oberfläche der Vorderseite (25) der Struktur eine Metallschicht (40) zu bilden, die wenigstens eine äußere Goldschicht (43) aufweist, derart, dass der Anschlussbereich (31) abgedeckt ist und dass der Anschlussbereich (31) vor einem Angriff durch den Reaktanten KOH geschützt ist; und
- die freigelegte Zone der Rückseite des Substrats mit dem Reaktanten KOH zu ätzen,
wobei das Verfahren den zusätzlichen Schritt umfasst, der darin besteht, wenigstens einen Höcker (50) für einen elektrischen Anschluss auf der äußeren Goldschicht (43) über dem Anschlussbereich (31) zu bilden, bevor das Substrat mit dem Reaktanten KOH geätzt wird.

2. Herstellungsverfahren nach Anspruch 1, bei dem die Struktur ein integrierter Membransensor ist, wobei das Verfahren außerdem die Schritte umfasst, die darin bestehen:
- vor dem Schritt des Ätzens mit dem Mittel KOH auf der Vorderseite (25) des Substrats (23) eine dielektrische Schicht (28) zu bilden und auf der dielektrischen Schicht (28) den wenigstens einen Anschlussbereich (31) zu bilden und
- die Rückseite (27) des Substrats (23) mit dem Reaktanten zu ätzen, um eine Membran des integrierten Sensors zu bilden,
**dadurch gekennzeichnet, dass** im Schritt des Bildens des wenigstens einen Höckers (50) für einen elektrischen Anschluss auf dem Anschlussbereich (31) die äußere Goldschicht (43) als Plattierungsbasis für die Bildung des wenigstens einen Höckers (50) für einen elektrischen Anschluss verwendet wird.

3. Verfahren nach einem der Ansprüche 1 oder 2, **dadurch gekennzeichnet, dass** der Höcker (50) für einen elektrischen Anschluss aus Gold besteht und durch Metallisieren gebildet wird.

4. Herstellungsverfahren nach einem der Ansprüche 1 bis 3, **dadurch gekennzeichnet, dass** vor der Bildung der äußeren Goldschicht (43) auf der Vorderseite (25) eine metallische Zwischenschicht (41) gebildet wird, die als Diffusionssperre und Haftungsförderer wirkt.

5. Herstellungsverfahren nach Anspruch 4, **dadurch gekennzeichnet, dass** die metallische Zwischenschicht (41) aus TiW, TiN oder aus TiW:N gebildet ist.

6. Herstellungsverfahren nach einem der Ansprüche 1 bis 5, **dadurch gekennzeichnet, dass** die äußere Goldschicht (43) durch Pulverisieren gebildet wird.

7. Herstellungsverfahren nach einem der Ansprüche 1 bis 6, **dadurch gekennzeichnet, dass** für die Bildung der äußeren Goldschicht (43) eine erste Goldschicht (43a) durch Pulverisieren gebildet wird und eine zweite Goldschicht (43b) auf der ersten Goldschicht (43a) durch Metallisieren gebildet wird.

8. Struktur während des Vorgangs des Ätzens durch den Reaktanten KOH, wobei diese Struktur ein Substrat (23) mit einer ersten Seite oder Vorderseite (25) und einer zweiten Seite oder Rückseite (27) umfasst, wobei dieses Substrat (23) aus einem Material auf Halbleiterbasis gebildet ist, das durch den Reaktanten KOH geätzt wird, und auf seiner Rückseite (27) eine Maskierungsschicht (75) aufweist, die eine Zone der Rückseite (27) des Substrats (23) freilegt, wobei diese Struktur wenigstens einen Anschlussbereich (31) umfasst, der auf der Vorderseite (25) angeordnet und aus einem Material gebildet ist, das durch den Reaktanten angegriffen werden kann, wobei diese Struktur außerdem eine Metallschicht (40) umfasst, die auf der gesamten Oberfläche der Vorderseite (25) gebildet ist, um so insbesondere den Bereich (31) abzudecken, wobei diese Metallschicht (40) wenigstens eine äußere Goldschicht (43) umfasst, die gegenüber dem Reaktanten beständig ist, wobei die äußere Goldschicht (43) wenigstens einen Höcker (50) für einen elektrischen Anschluss auf dem Bereich (31) aufweist.

9. Struktur nach Anspruch 8, **dadurch gekennzeichnet, dass** der Höcker (50) für einen elektrischen Anschluss aus Gold besteht.

10. Struktur nach einem der Ansprüche 8 oder 9, **dadurch gekennzeichnet, dass** die wenigstens eine Goldschicht (43) auf einer metallischen Zwischenschicht (41) angeordnet ist, die als Diffusionssperre und Haftungsförderer wirkt.

11. Struktur nach Anspruch 10, **dadurch gekennzeichnet, dass** die metallische Zwischenschicht (41) aus TiW, TiN oder aus TiW:N gebildet ist.

12. Struktur nach einem der Ansprüche 8 bis 11, **dadurch gekennzeichnet, dass** die wenigstens eine Goldschicht (43) eine pulverisierte Goldschicht ist.

13. Struktur nach einem der Ansprüche 8 bis 11, **dadurch gekennzeichnet, dass** die wenigstens eine Goldschicht (43) aus einer ersten pulverisierten Goldschicht (43a) und aus einer zweiten Goldschicht (43b), die auf die erste Goldschicht (43a) aufmetallisiert ist, gebildet ist.
